# FASCICULE DE BREVET EUROPEEN

(11) **EP 1 326 154 B1**
(45) Date de publication et mention de la délivrance du brevet: **16.03.2005**
(21) Numéro de dépôt: 02293111.7
(22) Date de dépôt: 17.12.2002
(51) Int. Cl.: G05F 3/26, H03L 7/089

(54) **Pompe à charge à très large plage de tension de sortie**
Ladungspumpe mit sehr grossem Ausgangsspannungsbereich
Charge pump with a very wide output voltage range

(30) Priorité: 03.01.2002 FR 0200034
(43) Date de publication de la demande: 09.07.2003
(73) Titulaire: ALCATEL, 75008 Paris (FR)
(72) Inventeur: Desortiaux, Vincent, 92270 Bois Colombes (FR)
(74) Mandataire: Lamoureux, Bernard

(56) Documents cités:
- EP-A- 0 778 510
- US-A- 6 124 755

## Description

La présente invention se rapporte à une pompe à charge capable de fonctionner avec une très large plage de tension de sortie s'étalant entre la masse et la tension d'alimentation.

Une telle pompe à charge selon l'invention est plus particulièrement prévue pour maximiser la plage de réglage d'un oscillateur commandé en tension d'une boucle à phase asservie et trouve donc une application particulièrement avantageuse dans les systèmes de transmission radioélectrique.

Une pompe à charge est un dispositif habituellement utilisé dans les boucles à phase asservie et est plus précisément disposé entre le comparateur de phase et le filtre de boucle. La boucle à phase asservie ou PLL (pour «phase locked loop ») désigne en effet un montage formé d'un oscillateur à phase asservi, ainsi que du comparateur de phase et du filtre associés.

L'oscillateur asservi en phase est prévu pour fournir un signal dont la phase est asservie à celle d'un signal de référence. Il s'agit d'un oscillateur commandé en tension dont le signal de sortie est appliqué à un comparateur de phase. La tension d'erreur fournie éventuellement par celui-ci est filtrée par un filtre passe-bas pour éliminer ses fluctuations éventuelles et appliquée à l'élément variable de l'oscillateur pour annuler la différence de phase.

Ainsi, suivant les signaux fournis par le comparateur de phase, le rôle de la pompe à charge est d'injecter ou de retirer un courant constant du filtre de boucle. Pour cela, une pompe à charge est constituée d'un bloc faisant office de source de courant du type miroir de courant et plus particulièrement, on trouve une première source de courant pour générer un courant positif et une seconde source de courant pour générer un courant négatif, de sorte que le courant de sortie soit contrôlé selon un système symétrique. La première source est prévue pour injecter un courant constant dans le filtre de boucle et la seconde source est prévue pour retirer un courant constant du filtre de boucle, en fonction des signaux fournis par le comparateur de phase. Chaque source doit alors être constante quelle que soit la tension du filtre de boucle. Il s'agit donc de pouvoir fournir un courant constant dont la valeur est égale à une valeur de référence sur la plus grande plage de tension de sortie possible. Or, dans des conditions de fonctionnement particulières, un problème est susceptible de se poser. Ainsi, lorsque la tension de sortie de la pompe à charge s'approche de la tension d'alimentation de la pompe à charge (respectivement de la masse), le transistor formant la source de courant qui génère un courant positif (respectivement qui génère un courant négatif) entre en régime linéaire, ce qui fausse les recopies de courant, et le courant de sortie n'est plus maintenu à la valeur de référence.

Une solution de l'art antérieur à ce problème, décrite dans la demande de brevet européen EP 0 778 510, consiste à mettre en oeuvre des sources de courant cascodées. Ce document de brevet se rapportent aux sources de courant bi-directionnelles fortement symétriques capables de générer des courants positif et négatif égaux sur une large plage de tension de sortie. Les courants positif et négatif générés sont de plus rendus égaux à un courant de référence avec une grande précision. Ce dispositif de l'art antérieur comprend une première et une deuxième source de courant cascodée chacune couplée à des miroirs de courant pour appliquer un courant de référence constant, respectivement en positif et en négatif, à partir d'une tension de sortie minimum jusqu'à une tension de sortie maximum entre la masse de la tension d'alimentation.

Cette solution propose donc d'utiliser des sources de courant ayant une impédance interne élevée. En effet, une augmentation de l'impédance interne de la source de courant permet de rendre le courant fourni davantage insensible à des variations de tensions aux bornes du dispositif.

Cette amélioration de l'impédance de sortie du dispositif permettant par la même d'atteindre l'objectif visé, à savoir l'application d'un courant de référence constant, soit en positif, soit en négatif, avec une très large plage de tension de sortie, est donc obtenue grâce à la mise en oeuvre de sources de courant cascodées.

Cependant, l'utilisation de sources cascodées nécessite de travailler à des tensions d'alimentation supérieures par rapport à l'utilisation de sources simples. De telles sources cascodées mettent en effet en oeuvre deux transistors au lieu d'un seul et, d'après le document de l'art antérieur, la tension d'alimentation minimum à appliquer est de trois volts. Ainsi, cet impératif de l'art antérieur empêche un fonctionnement avec de faibles tensions d'alimentation. En effet, dans ce cas, une faible tension d'alimentation, inférieure à la tension d'alimentation précitée, entraînerait une mauvaise recopie des courants puisqu'il n'est alors pas possible de placer les transistors dans le bon état de fonctionnement, à savoir l'état saturé qui se caractérise par une tension drain-source suffisamment grande.

D'autres solutions ne mettant pas en oeuvre de sources de courant cascodées sont également connues. Cependant, dans de telles solutions, l'adaptation de courant entre la source de courant positive et la source de courant négative n'est pas prise en compte. Ce phénomène de désadaptation entre la source de courant positive et la source de courant négative génère ainsi des parasites importants dans la fréquence de sortie de l'oscillateur en mode de fonctionnement asservi.

C'est par conséquent un objet de la présente invention de pallier aux inconvénients de l'art antérieur qui viennent d'être mentionnés et de proposer ainsi une pompe à charge capable de fonctionner avec une très large plage de tension de sortie pour fournir un courant constant, respectivement positif ou négatif, sur l'ensemble de la plage de tension de sortie et dont la valeur est rendue égale à la valeur d'un courant de référence, de façon à maximiser la plage de réglage d'un oscillateur commandé en tension d'une boucle à phase asservie.

A cet effet, l'invention prévoit de mettre en oeuvre au sein de la pompe à charge un comparateur de tension pour activer (et respectivement désactiver lorsqu'il n'est pas nécessaire) un système formé par un amplificateur opérationnel permettant de forcer le courant de sortie de la pompe à charge à la valeur de référence prédéterminée.

Plus précisément, on a déjà vu que lorsque la tension de sortie de la pompe à charge s'approche de la tension d'alimentation (respectivement de la masse), le transistor de la source de courant générant un courant positif (respectivement négatif), entre en régime linéaire et fausse par là-même les recopies de courant.

Un premier amplificateur opérationnel (respectivement en deuxième), associé à un premier comparateur (respectivement un deuxième), va alors permettre de forcer le transistor en miroir de la source de courant générant un courant positif (respectivement négatif) dans un état de fonctionnement similaire à celui du transistor de la source de courant, soit en régime linéaire, pour restaurer le miroir de courant et maintenir le courant de sortie à la valeur de référence.

Il s'agit donc de mettre en place un système de commutation symétrique qui active l'un ou l'autre des amplificateurs opérationnels, associé respectivement à l'une ou l'autre des sources de courant positif ou négatif, en fonction de valeurs de seuil prédéterminées, l'un des amplificateurs étant alors prévu pour restaurer le comportement du miroir de courant générant un courant positif lorsque la tension de sortie de la pompe à charge s'approche de la tension d'alimentation et l'autre étant alors prévu pour restaurer le comportement du miroir de courant générant un courant négatif lorsque la tension de sortie de la pompe à charge s'approche de la masse, de sorte que courant de sortie de la pompe à charge soit toujours constant et égal à une valeur de référence sur la plus large plage de tension de sortie possible.

La solution permet d'obtenir une plage de tension de sortie plus large qu'avec des sources cascodées en contrôlant précisément le courant de sortie du transistor basculant dans le mode linéaire respectivement pour la source générant un courant positif (dite source de courant « haute ») et pour la source générant un courant négatif (dite source de courant «basse»).

La solution permet également de limiter le phénomène de désadaptation susceptible de se produire à des tensions de sortie faibles et élevées entre la source de courant «haute» et la source de courant « basse » et permet donc de limiter les parasites à la fréquence de référence en sortie de l'oscillateur commandé en tension dans le mode de fonctionnement asservi grâce à la mise en oeuvre d'un système de commutation parfaitement symétrique.

L'invention concerne donc une pompe à charge polarisée entre une tension d'alimentation et la masse, comprenant une première source de courant associée à un transistor de recopie de courant en miroir et une seconde source de courant associée à un transistor de recopie de courant en miroir, ladite première et seconde source de courant fournissant un courant de référence constant, respectivement en positif et en négatif, sur une plage de tension de sortie de ladite pompe à charge allant d'une tension de sortie minimum jusqu'à une tension de sortie maximum entre la masse et la tension d'alimentation, ladite pompe à charge étant caractérisée en ce qu'elle comprend en plus un premier amplificateur opérationnel et un second amplificateur opérationnel, ledit premier amplificateur étant activé, respectivement désactivé, par un premier comparateur lorsque la tension de sortie de la ladite pompe à charge devient supérieure, respectivement inférieure, à une valeur de seuil prédéterminée pour forcer ledit transistor en miroir associé à ladite première source de courant à un régime de fonctionnement linéaire, respectivement saturé;

ledit second amplificateur étant activé, respectivement désactivé, par un second comparateur lorsque la tension de sortie de ladite pompe à charge devient inférieure, respectivement supérieure, à ladite valeur de seuil prédéterminée pour forcer ledit transistor en miroir associé à ladite seconde source de courant à un régime de fonctionnement linéaire, respectivement saturé.

D'autres caractéristiques et avantages de la présente invention apparaîtront plus clairement à la lecture de la description qui suit donnée à titre d'exemple illustratif et non limitatif et faite en référence à la figure annexée unique :

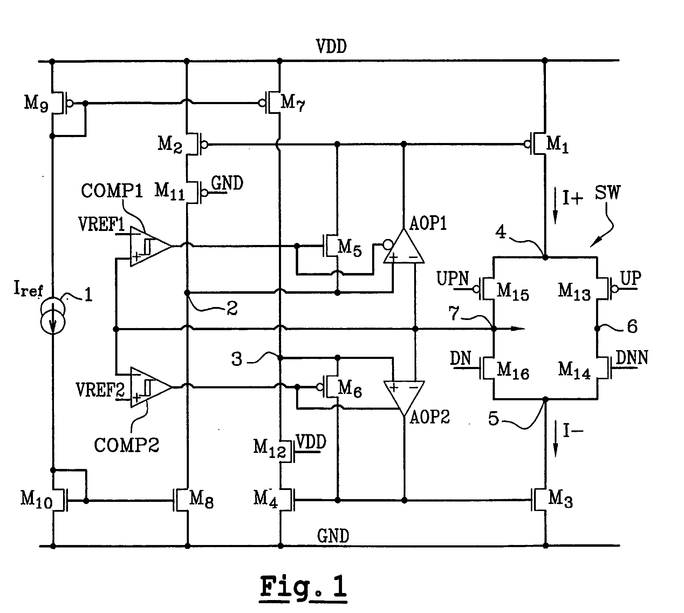

- la figure 1, qui est un schéma illustrant le dispositif de pompe à charge selon la présente invention.

La figure 1 décrit donc une pompe à charge selon l'invention qui consiste plus précisément en une source de courant bi-directionnelle polarisée entre la tension d'alimentation V_{DD} et la masse GND. La source de courant bi-directionnelle formant pompe à charge est réalisée selon la technologie CMOS (acronyme pour l'expression anglo-saxonne « complementary Metal Oxyde Semiconductor »).
La pompe à charge comprend une première branche formée par un transistor MOS de type P monté en diode M9, une alimentation de courant 1 générant un courant de référence Iref et un transistor MOS de type N monté en diode M10, qui sont connectés en série.

Une deuxième branche est formée par un premier transistor MOS M8, un deuxième transistor MOS M11 avec un noeud intermédiaire 2 entre eux et un troisième transistor MOS M2 de recopie de courant, tous connectés en série. Le transistor M2 est en miroir avec un transistor MOS M1 formant la source de courant positif.

Ainsi la source du transistor M8 est reliée à la masse GND et sa grille est connectée à la grille du transistor MOS M10 monté en diode de la première branche. La source du transistor M2 est connecté à la tension d'alimentation V_{DD} et son drain est connecté à la source du transistor M11. Les drains des transistors M8 et M11 sont reliés ensemble avec le noeud intermédiaire 2 entre eux. La grille du transistor M11 est polarisée soit à la tension d'alimentation V_{DD}, soit à la masse GND.

Une troisième branche est formée par un premier transistor MOS M7, un deuxième transistor MOS M12 avec un noeud intermédiaire 3 entre eux et un troisième transistor MOS M4 de recopie de courant, tous connectés en série. Le transistor M4 est en miroir avec un transistor MOS M3 formant la source de courant négatif. Ainsi, la source de M7 est connectée à la tension d'alimentation V_{DD} et sa grille est connectée à la grille du transistor MOS monté en diode M9 de la première branche. La source du transistor de recopie de courant M4 est connectée à la masse GND et son drain est connecté à la source de M12. Les drains des transistors M12 et M7 sont reliés ensemble avec le noeud intermédiaire 3 entre eux. La grille de M12 est quant à elle soit polarisée à la tension d'alimentation V_{DD}, soit polarisée à la masse.

Une quatrième branche, ou branche de sortie, est constituée par un premier transistor MOS M1 dont la source est connectée à la tension d'alimentation V_{DD} et dont la grille est connectée à la grille du transistor MOS M2 de recopie de courant de la deuxième branche formant ainsi miroir de courant afin de recopier le courant de référence Iref sur son drain où un courant positif I+ est généré à un premier noeud commun 4. Le transistor M1 fait donc office de source de courant positif.

La quatrième branche comprend aussi un second transistor MOS M3 dont la source est connectée à la masse et dont la grille est connectée à la grille du transistor MOS M4 de recopie de courant formant ainsi miroir de courant afin de recopier le courant de référence Iref sur son drain où un courant négatif I- est généré à un second noeud commun 5. Le transistor M3 fait donc office de source de courant négatif.

Un dispositif de commutation SW comprend une première paire de transistor MOS complémentaires M13 et M14 qui forme une première sous-branche et une deuxième paire de transistors MOS complémentaires M15 et M16, formant une deuxième sous-branche, reliés entre eux par un noeud 7 qui fait office de noeud de sortie de la pompe à charge vers un filtre de boucle et un oscillateur commandé en tension. Les deux sous-branches sont connectées en parallèle entre les deux noeuds communs 4 et 5. Les paires de transistors complémentaires sont commandées par des signaux de commande, respectivement UP, DNN et UPN, DN, de façon à sélectionner soit le courant positif I+, soit le courant négatif I- qui doit être fourni par la pompe à charge au noeud de sortie 7.

La pompe à charge comprend également un premier amplificateur opérationnel AOP1 dont l'entrée négative est connectée au noeud de sortie 7 de la pompe à charge, dont l'entrée positif est connectée au noeud intermédiaire 2 de la deuxième branche et dont la sortie est placée au même potentiel que la grille de la source de courant positif M1.

L'amplificateur opérationnel AOP1 est activé (respectivement désactivé) par l'intermédiaire d'un premier comparateur COMF1 et d'un transistor MOS M5 faisant office de commutateur.

La pompe à charge comprend aussi un deuxième amplificateur opérationnel AOP2 dont l'entrée négative est connectée au noeud de sortie 7 de la pompe à charge, dont l'entrée positive est connecté au noeud intermédiaire 3 de la troisième branche et dont la sortie est placée au même potentiel que la grille de la source de courant négatif M3.

L'amplificateur AOP2 est quant à lui activé (respectivement désactivé) par l'intermédiaire d'un deuxième comparateur COMP2 et d'un transistor MOS M6 faisant office de commutateur.

La pompe à charge selon l'invention comprend donc un premier circuit miroir de courant constitué du transistor MOS monté en diode M10, du transistor MOS M8, du transistor MOS M2 et du transistor MOS M1, qui recopie le courant de référence Iref pour fixer le courant positif I+ sur le drain du transistor MOS M1 de sorte que I+ = Iref.

Un second miroir de courant, constitué du transistor MOS monté en diode M9, du transistor MOS M7, du transistor MOS M4 et du transistor MOS M3, recopie le courant de référence Iref pour fixer le courant négatif I- sur le drain du transistor MOS M3 de sorte que I- = Iref.

La première source de courant M1, connectée au transistor de recopie de courant M2, permet donc d'appliquer sur le noeud de sortie 7 de la pompe à charge le courant de référence constant Iref en positif et la deuxième source de courant M3 connectée au transistor de recopie de courant M4, permet quant à elle d'appliquer sur le noeud de sortie 7 le courant de référence Iref constant en négatif.

Il est important de noter que c'est le filtre de boucle en sortie (non représenté) qui impose le potentiel du noeud de sortie 7 de la pompe à charge.

Prenons un exemple de fonctionnement de la pompe à charge selon l'invention avec la source de courant « basse », à savoir la source de courant négatif M3. Le courant I- est alors retiré du filtre de boucle. Dans ces conditions, le transistor M16 utilisé en commutateur est rendu passant en appliquant le signal DN équivalent à la tension d'alimentation V_{DD} sur sa grille.

Le système décrit étant complètement symétrique, une description similaire à celle qui suit peut être faite pour la source de courant « haute », à savoir la source de courant positif M1.

Ainsi, quand la tension de sortie est faible (proche de la masse), la tension drain-source du transistor M3 devient inférieur à la tension de saturation et le transistor M3 bascule dans un régime de fonctionnement linéaire. Le transistor de recopie de courant M4 étant lui dans un régime saturé, la recopie du courant Iref est alors faussée. Sans le mécanisme mis en oeuvre par l'invention à travers l'action du comparateur COMP2 et de l'amplificateur opérationnel AOP2 associé, le courant circulant à travers la source de courant négatif M3 diminuerait rapidement, celui-ci étant alors dépendant de la tension drain-source de M3.

Le but est alors de restaurer le miroir de courant entre le transistor de référence M4 et la source de courant M3 en forçant le transistor M4 dans le même état que M3, soit en forçant M4 à basculer en régime de fonctionnement linéaire. Les potentiels de grille, source et drain de M4 et M3 doivent donc être rendus identiques, ce qui est précisément le rôle de l'amplificateur opérationnel AOP2.

Le potentiel de drain de M4 doit donc être asservi au potentiel du noeud commun 5, ce qui revient à asservir le potentiel du noeud intermédiaire 3 de la troisième branche au potentiel du noeud de sortie 7 de la pompe à charge, lorsque le transistor M12 avantageusement taillé de manière identique au transistor M16 faisant office de commutateur rendu passant est commandé par la tension de grille V_{DD}. Cet asservissement estréalisé par l'amplificateur opérationnel AOP2 qui est activé par le comparateur COMP2 quand la tension de sortie de la pompe à charge passe au-dessous d'une certaine valeur de seuil prédéterminée, qui peut par exemple être prise égale à V_{DD}/2.

En effet COMP2 reçoit sur son entrée - la tension de sortie de la pompe à charge et une tension de référence Vref2 égale à la valeur de seuil prédéterminée est appliquée sur son entrée +. COMP2 active alors AOP2 quand la tension de sortie devient inférieure à la valeur de seuil Vref2 et l'amplificateur opérationnel AOP2 agit alors sur sa sortie pour imposer sur son entrée +, reliée au noeud 3, le potentiel de sont entrée-, reliée au noeud de sortie 7.

L'amplificateur opérationnel AOP2 permet donc de maintenir à la fois la même tension grille-source et drains-source pour le transistor de référence M4 et pour le transistor source de courant M3 lorsque la tension de sortie de la pompe à charge passe en dessous d'une certaine valeur de seuil prédéterminée. Ces deux transistors sont alors dans le même état de fonctionnement linéaire et le courant de sortie I- est constant et égal à Iref. La pompe à charge peut donc travailler de façon optimale à tension de sortie basse avec des transistors qui sont désaturés car on a un mécanisme capable d'assurer une bonne recopie du courant de référence en maintenant la source de courant M3 et son miroir M4 dans le même état.

Quand la tension de sortie devient supérieure à la valeur de seuil Vref2, le comparateur COMP2 désactive l'amplificateur AOP2 et rend passant le transistor M6 utilisé comme commutateur. De cette façon, le comparateur COMP2 permet de s'assurer que le transistor M7 reste correctement saturé quand la tension de sortie de la pompe à charge est haute.

Le courant drain-source de M7 est alors égal au courant de référence quel que soit la tension de sortie de la pompe à charge.

Un fonctionnement similaire à celui qui vient d'être décrit est réalisé avec le comparateur COMF1 et l'amplificateur opérationnel AOP1 en ce qui concerne la source de courant « haute », soit la source de courant positif M1. Dans ce cas, le comparateur COMF1 active l'amplificateur opérationnel AOP1 lorsque la tension de sorite de la pompe à charge devient supérieure à une tension de référence Vref1 égale à une valeur de seuil prédéterminée, par exemple V_{DD}/2. En effet, quand la tension de sortie de la pompe à charge est haute (proche de V_{DD}), le transistor M1 bascule en régime linéaire, l'amplificateur AOP1 permet alors de forcer le fonctionnement du transistor de recopie de courant en miroir M7 dans le même état.

La pompe à charge selon l'invention permet d'obtenir un courant de référence constant, respectivement en positif et en négatif, sur une plus grande plage de tension de sortie qu'avec l'art antérieur car on peut travailler avec des transistors qui sont désaturés. Des résultats de simulation ont ainsi montré qu'il est possible d'assurer un courant constant sur toute une plage de tension de sortie entre une tension de sortie minimum correspondant à la masse plus 200 mv (millivolt) et une tension de sortie maximum correspondant à la tension d'alimentation moins 200 mv. La possibilité d'avoir un courant constant en sortie de la pompe à charge sur une plus grande plage de tension de sortie permet de piloter l'oscillateur commandé en tension placé derrière la pompe à charge sur une plage de tension plus important et permet donc d'augmenter la plage de variation de fréquence en sortie de l'oscillateur.

De plus, l'invention met en oeuvre un système de commutation parfaitement symétrique qui active l'un ou l'autre des amplificateurs opérationnels AOP1 ou AOP2 en fonction de valeurs de seuils prédéterminées. Ainsi, avec ce système, le phénomène de désadaptation entre la source de courant positif M1 et la source de courant négatif M3 est réduit quand la boucle est verrouillée et la réduction du défaut d'adaptation entre les sources M1 et M3 permet de diminuer les parasites dans la fréquence de référence mesurée à la sortie de l'oscillateur.

Enfin, le pompe à charge selon l'invention permet de descendre la tension d'alimentation autour de 2,5 V (volts) puisque les sources de courant mis en oeuvre ne sont pas des sources cascodées.

## Revendications

1. Pompe à charge polarisée entre une tension d'alimentation (V_{DD}) et la masse (GND), comprenant une première source de courant (M1) associée à un transistor de recopie de courant en miroir (M2) et une seconde source de courant (M3) associée à un transistor de recopie de courant en miroir (M4), ladite première et seconde source de courant fournissant un courant de référence constant (IRef), respectivement en positif (I+) et en négatif (I-), sur une plage de tension de sortie de ladite pompe à charge allant d'une tension de sortie minimum jusqu'à une tension de sortie maximum entre la masse (GND) et la tension d'alimentation (V_{DD}), ladite pompe à charge étant **caractérisée en ce qu'**elle comprend en plus un premier amplificateur opérationnel (AOP1) et un second amplificateur opérationnel (AOP2), ledit premier amplificateur (AOP1) étant activé, respectivement désactivé, par un premier comparateur (COMF1) lorsque la tension de sortie de ladite pompe à charge devient supérieure, respectivement inférieure, à une valeur de seuil prédéterminée (Vref) pour forcer ledit transistor en miroir (M2) associé à ladite première source de courant (M1) à un régime de fonctionnement linéaire, respectivement saturé;
ledit second amplificateur (AOP2) étant activé, respectivement désactivé, par un second comparateur (COMP2) lorsque la tension de sortie de ladite pompe à charge devient inférieure, respectivement supérieure, à ladite valeur de seuil prédéterminée pour forcer ledit transistor en miroir (M4) associé à ladite seconde source de courant (M3) à un régime de fonctionnement linéaire, respectivement saturé.

2. Pompe à charge selon la revendication 1, **caractérisée en ce qu'**elle comprend en plus un dispositif de commutation (SW) comprenant une première paire de transistors MOS complémentaires (M13, M14) mis en parallèle avec une deuxième paire de transistors MOS complémentaires (M15, M16), lesdites paires de transistors complémentaires étant commandées par des signaux de commande (UP, DNN, UPN, DN) de façon à sélectionner soit le courant positif (I+), soit le courant négatif (I-) devant être fourni en sortie par ladite pompe à charge.

3. Pompe à charge selon la revendication 1 ou 2, **caractérisée en ce que** la valeur de seuil prédéterminée de la tension de sortie de ladite pompe à charge est prise égale à la valeur de la tension d'alimentation divisée par deux (VDD/2).

4. Boucle à phase asservie comprenant un filtre de boucle et un oscillateur commandé en tension, **caractérisée en ce qu'**elle met en oeuvre la pompe à charge selon l'une des revendications précédentes en amont de l'ensemble constitué dudit filtre et dudit oscillateur.

## Patentansprüche

1. Ladungspumpe, polarisiert zwischen einer Versorgungsspannung (Vdd) und der Masse (GND), beinhaltend eine einem Stromspiegelungstransistor (M2) zugeordnete erste Stromquelle (M1) und eine einem Stromspiegelungstransistor (M4) zugeordnete zweite Stromquelle (M3), wobei die besagte erste und zweite Stromquelle einen konstanten Referenzstrom (Iref) liefern, welcher positiv (I+) beziehungsweise negativ (I-) sein kann, und zwar über einen Ausgangsspannungsbereich der besagten Ladungspumpe hinweg, welcher von einer minimalen Ausgangsspannung bis zu einer maximalen Ausgangsspannung zwischen dem Massepotential (GND) und der Versorgungsspannung (Vdd) reicht, wobei die besagte Ladungspumpe **dadurch gekennzeichnet ist, daß** sie ferner einen ersten Operationsverstärker (AOP1) und einen zweiten Operationsverstärker (AOP2) beinhaltet, wobei der besagte erste Operationsverstärker (AOP1) von einem ersten Komparator (COMP1) aktiviert beziehungsweise deaktiviert wird, wenn die Ausgangsspannung der besagten Ladungspumpe einen bestimmten zuvor festgelegten Schwellenwert (Vref) überschreitet beziehungsweise unterschreitet, um den besagten Spiegelungstransistor (M2), welcher der besagten Stromquelle (M1) zugeordnet ist, in einen linearen beziehungsweise gesättigten Betriebszustand zu bringen,
wobei der besagte zweite Operationsverstärker (AOP2) von einem zweiten Komparator (COMP2) aktiviert beziehungsweise deaktiviert wird, wenn die Ausgangsspannung der besagten Ladungspumpe den besagten zuvor festgelegten Schwellenwert unterschreitet beziehungsweise überschreitet, um den besagten Spiegelungstransistor (M4), welcher der besagten Stromquelle (M3) zugeordnet ist, in einen linearen beziehungsweise gesättigten Betriebszustand zu bringen.

2. Ladungspumpe gemäß Anspruch 1, **dadurch gekennzeichnet, daß** diese ferner eine Umschaltvorrichtung (SW) beinhaltet, welche ein erstes Komplementärpaar von MOS-Transistoren (M13, M14) beinhaltet, das zu einem zweiten Komplementärpaar von MOS-Transistoren (M15, M16) parallel geschaltet ist, wobei die besagten Transistor-Komplementärpaare so mit Steuersignalen (UP, DNN, UPN, DN) beaufschlagt werden, daß als Strom, den die Ladungspumpe an ihrem Ausgang zu liefern hat, entweder der positive Strom (I+) oder der negative Strom (I-) ausgewählt wird.

3. Ladungspumpe gemäß Anspruch 1 oder 2, **dadurch gekennzeichnet, daß** als zuvor festgelegter Schwellenwert der Ausgangsspannung der besagten Ladungspumpe der durch 2 geteilte Wert der Versorgungsspannung verwendet wird (Vdd/2).

4. Phasenregelschleife, beinhaltend ein Schleifenfilter und einen spannungsgesteuerten Oszillator, **dadurch gekennzeichnet, daß** in dieser Phasenregelschleife im Signalweg vor der aus dem besagten Filter und dem besagten Oszillator bestehenden Baugruppe die Ladungspumpe gemäß einem oder mehreren der vorgenannten Ansprüche zur Anwendung kommt.

## Claims

1. A charge pump adapted to be biased to a voltage between a supply voltage (VDD) and a ground voltage (GND) and comprising a first current source (M₁) associated with a mirror current copier transistor (M₂) and a second current source (M₃) associated with a mirror current copier transistor (M₄), said first and second current sources supplying a constant reference current (I_{ref}) that is respectively positive (I+) and negative (I-) over a range of output voltages of said charge pump from a minimum output voltage to a maximum output voltage between the ground voltage (GND) and the supply voltage (VDD), said charge pump being **characterized in that** it further comprises a first operational amplifier (AOP1) that is activated, respectively deactivated, by a first comparator (COMP1) when the output voltage of said charge pump rises above, respectively falls below, a predetermined threshold value (VREF) to force said mirror transistor (M₂) associated with said first current source (M₁) into a linear, respectively saturated, range of operating conditions, and a second amplifier (AOP2) that is activated, respectively deactivated, by a second comparator (COMP2) when the output voltage of said charge pump falls below, respectively rises above, said predetermined threshold value to force said mirror transistor (M₄) associated with said second current source (M₃) into a linear, respectively saturated, range of operating conditions.

2. A charge pump according to claim 1, **characterized in that** it further comprises a switching device (SW) comprising a first pair of complementary MOS transistors (M₁₃, M₁₄) connected in parallel with a second pair of complementary MOS transistors (M₁₅, M₁₆), said pairs of complementary transistors being controlled by control signals (UP, DNN, UPN, DN) to select either the positive current (I+) or the negative current (I-) to be supplied at its output by said charge pump.

3. A charge pump according to claim 1 or claim 2, **characterized in that** the predetermined threshold value of the output voltage of said charge pump is made equal to the half value of the supply voltage (VDD/2).

4. A phase-locked loop comprising a loop filter and a voltage-controlled oscillator, **characterized in that** it employs a charge pump according to any one of the preceding claims on the input side of the combination comprising said filter and said oscillator.
